# FASCICULE DE BREVET EUROPEEN

(11) **EP 2 946 472 B1**
(45) Date de publication et mention de la délivrance du brevet: **22.02.2017**
(21) Numéro de dépôt: 14700875.9
(22) Date de dépôt: 16.01.2014
(51) Int. Cl.: H03K 17/955, H03K 17/965, H03K 17/945

(54) **DISPOSITIF DE COMMANDE À DÉTECTION CAPACITIVE**
STEUERUNGSVORRICHTUNG MIT KAPAZITIVER DETEKTION
CONTROL DEVICE HAVING CAPACITIVE DETECTION

(30) Priorité: 17.01.2013 FR 1350396
(43) Date de publication de la demande: 25.11.2015
(73) Titulaire: Delphi Technologies, Inc., Troy MI 48007 (US)
(72) Inventeur: MICHEL, Christophe, F-67230 Westhouse (FR); MOLARD, Yannick, F-67130 Hersbach (FR)
(74) Mandataire: Delphi France SAS
(86) Numéro de dépôt international: PCT/EP2014/050805
(87) Numéro de publication internationale: WO 2014/111470

(56) Documents cités:
- EP-A1- 2 434 645
- EP-A2- 1 736 354
- DE-A1-102006 035 837
- US-A1- 2011 298 699

## Description

### DOMAINE TECHNIQUE

L'invention est relative à dispositif de commande à détection capacitive.

### ARRIERE-PLAN TECHNOLOGIQUE DE L'INVENTION

La multiplicité des dispositifs de commandes et leur agencement au voisinage les uns des autres a amené à pourvoir certains de ces dispositifs de détecteur d'approche capacitive. En approchant la main, un utilisateur déclenche un signal qu'il peut percevoir tel un signal sonore, un rétroéclairage, une vibration ou encore le déverrouillage du dispositif.

Traditionnellement pour réaliser une détection d'approche capacitive, il est nécessaire d'avoir un détecteur capacitif, également parfois nommé driver capacitif, un plan de masse et une électrode, également parfois nommée antenne, de sorte à détecter les variations de capacité créé entre l'électrode et le plan de masse. L'électrode est conventionnellement réalisée par une pièce rapportée qui peut être un fil électrique, un film métallique flexible collé sous une pièce plastique, une antenne sérigraphiée sur le circuit imprimé ou une antenne métallique soudée sur le circuit imprimé ou en contact avec celui-ci tel par exemple un ressort.

La solution conventionnelle présente les problèmes que d'une part l'intégration de l'électrode nécessite un espace, surface ou volume, supplémentaire difficilement disponible et, d'autre part, le coût général du dispositif est augmenté du coût associé de l'électrode mais également des coûts associés tels ceux des opérations de fabrication.

Le brevet EP1736354 divulgue un dispositif de commande à détection capacitive comprenant un moyen de détection de déplacements d'une bouton-poussoir, la bouton-poussoir étant fixé sur la carte par une armature métallique qui s'agit comme l'électrode pour la détection d'approche capacitive de l'interface.

### RESUME DE L'INVENTION

La présente invention résout les problèmes ci-dessus mentionnés en proposant un dispositif, de commande à détection capacitive comprenant une carte électronique pourvue d'un moyen de détection de déplacements d'une interface manuelle qui lui est directement liée et d'un détecteur capacitif connecté à une électrode. Le moyen est fixé sur la carte par une armature métallique. L'armature est de plus électriquement connectée au détecteur capacitif de sorte à former l'électrode pour la détection d'approche capacitive de l'interface.

L'armature est pourvue de pattes de fixations soudées à la carte électronique pour la tenue mécanique. L'une des pattes est de plus électriquement connectée au détecteur capacitif. De plus, le détecteur capacitif peut avantageusement être intégré à un microcontrôleur de la carte électronique. Le moyen, de détection de déplacements peut être un potentiomètre, un encodeur annulaire, un encodeur axial ou un moyen électronique ou optique ou selon toute autre technologie.

De plus, l'approche de l'interface, déclenche un signal perceptible par un utilisateur tel un signal sonore, lumineux ou haptique tel une vibration. L'interface manipulable peut être une molette rotative ou toute autre sorte de boutons, curseurs ou joystick.

L'invention est également relative à un module de commande comprenant au moins un dispositif réalisé selon les paragraphes précédents. Le module peut permettre de commander la radio ou l'air conditionné ou être un sélecteur de fonctions quelque fonction que ce soit.

### DESCRIPTION DES FIGURES

Un mode de réalisation de l'invention est maintenant décrit par l'intermédiaire des figures suivantes.
La Figure 1 est une vue d'ensemble d'un module de commande à molettes rotatives.
La Figure 2 est une vue de la carte électronique du module de la Figure 1.
Les Figures 3, 4 et 5 représentent successivement un potentiomètre, un encodeur annulaire et un encodeur axial, tous pouvant être fixés par une armature sur la carte de la Figure 2.
Les Figures 6 et 7 sont deux représentations alternatives de connexion de la carte de la Figure 2.

### DESCRIPTION DES MODES DE REALISATION PRÉFÉRÉS

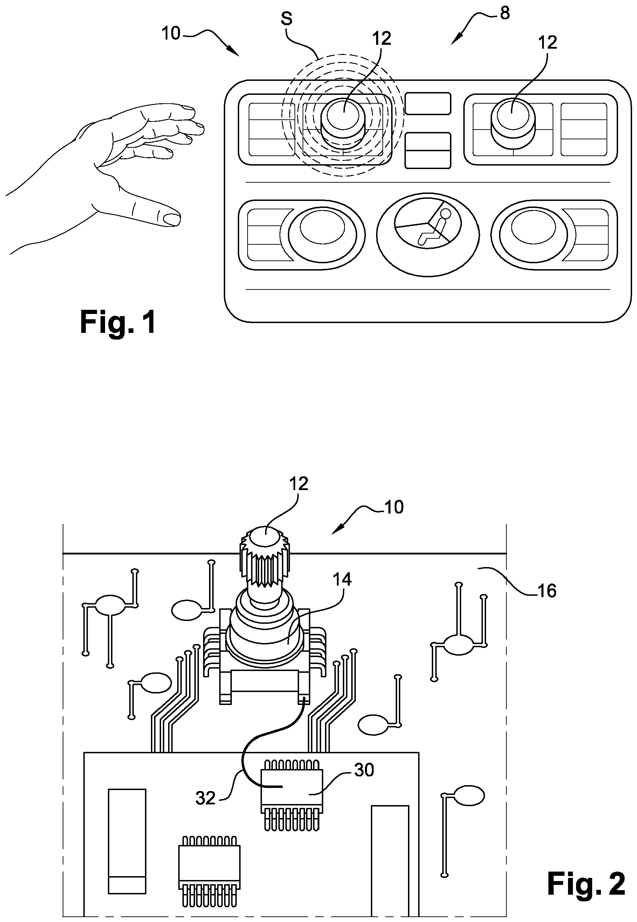

Selon la Figure 1 un module 8 de commande automobile est présenté. Le module 8 comprend une façade de style pourvue de deux molettes 12 de sélection en partie haute et des molettes de commande du système d'air conditionné en partie basse. Le module 8 est pourvu d'un dispositif 10 de détection d'approche aussi, une utilisatrice approche la main du module 8 et une molette 12 émet un signal S, symbolisé sur la Figure par les cercles concentriques entrés autour de la molette 12. Le signal S est émis avant que la main ne soit en contact avec la molette 12. Le signal peut être de n'importe quelle nature par exemple sonore, un « bip », un carillon ou le bruit d'une vibration, il peut également être lumineux tel le rétroéclairage d'un logotype dessiné sur la molette 12.

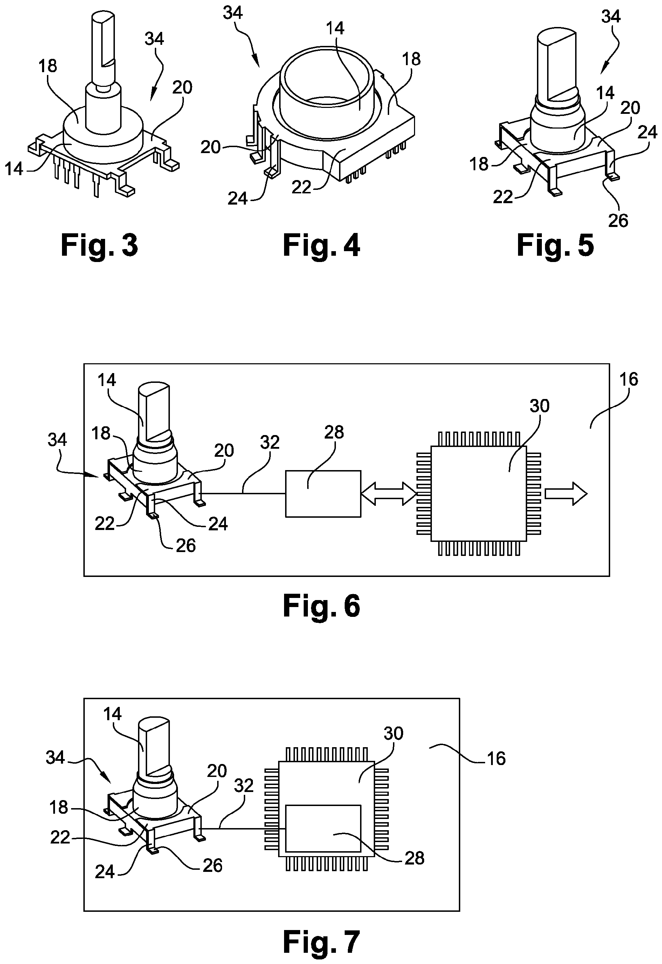

Selon la Figure 2, le dispositif 10 de détection comprend la molette rotative 12 qui entraine un encodeur 14 placé juste derrière la façade de style. Il peut s'agir de n'importe quel moyen permettant de détecter les déplacements de la molette 12, par exemple un encodeur mécanique 14 tel un potentiomètre, un encodeur annulaire ou un encodeur axial, respectivement présentés sur les Figures 3, 4 et 5. Il peut également s'agir d'un moyen électronique ou optique ou selon n'importe quelle technologie. L'encodeur 14 est électriquement et mécaniquement connecté à une carte électronique 16. D'un point de vue électrique, l'encodeur 14 transforme un courant électrique d'entrée en fonction des rotations de la molette 12 et, du point de vue mécanique, l'encodeur 14 est agencé dans un boitier 18 lui-même fixé au moyen d'une armature métallique 20 à la carte 16. L'armature 20 comprend une partie principale 22 pourvue d'un orifice central au travers duquel passe l'extension mécanique de liaison entre l'encodeur 14 et la molette 12. L'armature 20 s'agence sur le boitier 18, parallèlement à la carte 16 et, à sa périphérie, la partie principale 22 est pourvue de pattes de fixation 24 pliées à angle droit relativement à la partie principale 22 et s'étendant le long des côtés du boitier 18 jusqu'à une extrémité distale 26 soudée à la carte 16. Ainsi fait, l'encodeur 14 est maintenu en place sur la carte électronique, le boitier 18 étant emprisonné entre la partie principale 22, les pattes 24 et la carte électronique 16.

Selon les Figures 6 et 7, la carte électronique 16 est également pourvue d'un circuit électronique de détection capacitive 28 électriquement connecté, d'une part au microcontrôleur 30 principal de la carte 16 et d'autre part à une des pattes de fixation 24 de l'encodeur 14. La carte électronique 16 est pourvue d'une piste spécifique 32 pour assurer cette liaison. Ainsi connecté, l'armature métallique 20 devient l'électrode de détection capacitive 34 liée au détecteur 14. L'armature 20 a donc un rôle mécanique, la fixation de l'encodeur 14 sur la carte 16, et un rôle électronique, électrode 34 de détection capacitive. L'électrode 34 repère les variations de champ capacitif entre l'armature 20 et le plan de masse de la carte 16, variations créées par l'approche de la main - Figure 1.

Par ailleurs, tel que schématisé sur la Figure 7, il existe des microcontrôleurs 30 intégrant un circuit électronique de détection capacitive 28. Ainsi, peut être créé un dispositif de détection d'approche sans que soit nécessaire de composant supplémentaire.

## Revendications

1. Dispositif (10) de commande à détection capacitive comprenant une carte électronique (16) pourvue d'un moyen (14) de détection de déplacements d'une interface (12) manuelle qui lui est directement liée et d'un détecteur capacitif (28) connecté à une électrode (34), le moyen (14) étant fixé sur la carte (16) par une armature (20) métallique **caractérisé en ce que** l'armature (20) est de plus électriquement connecté au détecteur capacitif (28) de sorte à être l'électrode (34) pour la détection d'approche capacitive de l'interface (12), et **en ce que** ledit interface (12) est une molette rotative.

2. Dispositif (10) selon la revendication précédente dans lequel l'armature (20) est pourvue de pattes de fixations (24) soudées à la carte électronique (16) pour la tenue mécanique, l'une des pattes (16) étant de plus électriquement connectée au détecteur capacitif (28).

3. Dispositif (10) selon l'une quelconque des revendications précédentes dans lequel le détecteur capacitif (28) est intégré à un microcontrôleur (30) de la carte électronique (16).

4. Dispositif (10) selon l'une quelconque des revendications précédentes dans lequel le moyen (14) de détection de déplacements est un potentiomètre.

5. Dispositif (10) selon l'une quelconque des revendications 1 à 3 dans lequel le moyen (14) de détection de déplacements est un encodeur annulaire.

6. Dispositif (10) selon l'une quelconque des revendications 1 à 3 dans lequel le moyen (14) de détection de déplacements est un encodeur axial.

7. Dispositif (10) selon l'une quelconque des revendications 1 à 3 dans lequel le moyen (14) de détection de déplacements est un moyen électronique ou optique.

8. Dispositif (10) selon l'une quelconque des revendications précédentes dans lequel la détection de l'approche de l'interface (12) déclenche un signal (S) perceptible par un utilisateur tel un signal sonore, lumineux ou haptique.

9. Module de commandes (8) comprenant au moins un dispositif (10) réalisé selon l'une quelconque des revendications précédentes.

## Patentansprüche

1. Steuerungsvorrichtung (10) mit kapazitiver Detektion, enthaltend eine elektronische Karte (16), die mit einer Detektionseinrichtung (14) zur Detektion von Verlagerungen einer manuellen Schnittstelle (12) versehen ist, die direkt mit dieser verbunden ist, sowie mit einem kapazitiven Sensor (28), der an eine Elektrode (34) angeschlossen ist, wobei die Einrichtung (14) über eine Metallbewehrung (20) an die Karte (16) befestigt ist, **dadurch gekennzeichnet, dass** die Bewehrung (20) zudem elektrisch an den kapazitiven Sensor (28) derart angeschlossen ist, dass sie die Elektrode (34) zur kapazitiven Detektion der Annäherung der Schnittstelle (12) bildet, und dass die Schnittstelle (12) ein Rändelrad ist.

2. Vorrichtung (10) nach dem vorangehenden Anspruch, wobei die Bewehrung (20) mit Befestigungslaschen (24) versehen ist, die für den mechanischen Halt mit der elektronischen Karte (16) verlötet sind, wobei eine der Laschen (16) ferner elektrisch mit dem kapazitiven Sensor (28) verbunden ist.

3. Vorrichtung (10) nach einem der vorangehenden Ansprüche, wobei der kapazitive Sensor (28) einem Mikrokontroller (30) der elektronischen Karte (16) integriert ist.

4. Vorrichtung (10) nach einem der vorangehenden Ansprüche, wobei die Einrichtung (14) zur Detektion von Verlagerungen ein Potentiometer ist.

5. Vorrichtung (10) nach einem der Ansprüche 1 bis 3, wobei die Einrichtung (14) zur Detektion von Verlagerungen ein ringförmiger Encoder ist.

6. Vorrichtung (10) nach einem der Ansprüche 1 bis 3, wobei die Einrichtung (14) zur Detektion von Verlagerungen ein axialer Encoder ist.

7. Vorrichtung (10) nach einem der Ansprüche 1 bis 3, wobei die Einrichtung (14) zur Detektion von Verlagerungen eine elektronische oder optische Einrichtung ist.

8. Vorrichtung (10) nach einem der vorangehenden Ansprüche, wobei die Detektion der Annäherung der Schnittstelle (12) ein Signal (S) auslöst, das von einem Benutzer wahrnehmbar ist, wie etwa ein Tonsignal, ein Lichtsignal oder ein haptisches Signal.

9. Steuerungsmodul (8) mit zumindest einer Vorrichtung (10) nach einem der vorangehenden Ansprüche.

## Claims

1. Control device (10) having capacitive detection comprising an electronic card (16) provided with a means (14) for detecting displacements of a manual interface (12) which is directly tied to it and a capacitive detector (28) connected to an electrode (34), the means (14) being fixed on the card (16) by a metallic casing (20), **characterized in that** the casing (20) is moreover electrically connected to the capacitive detector (28) so as to be the electrode (34) for detecting capacitive approach to the interface (12), and **in that** said interface (12) is a rotary knob.

2. Device (10) according to the preceding claim, in which the casing (20) is provided with fixing claws (24) soldered to the electronic card (16) for mechanical holding, one of the claws (16) being moreover electrically connected to the capacitive detector (28).

3. Device (10) according to either of the preceding claims, in which the capacitive detector (28) is integrated into a microcontroller (30) of the electronic card (16).

4. Device (10) according to any one of the preceding claims, in which the means (14) for detecting displacements is a potentiometer.

5. Device (10) according to any one of Claims 1 to 3, in which the means (14) for detecting displacements is an annular encoder.

6. Device (10) according to any one of Claims 1 to 3, in which the means (14) for detecting displacements is an axial encoder.

7. Device (10) according to any one of Claims 1 to 3, in which the means (14) for detecting displacements is an electronic or optical means.

8. Device (10) according to any one of the preceding claims, in which the detection of the approach to the interface (12) triggers a signal (S) perceptible to a user such as an audible, luminous or haptic signal.

9. Control module (8) comprising at least one device (10) embodied according to any one of the preceding claims.
